# EUROPEAN PATENT SPECIFICATION

(11) **EP 1 737 030 B1**
(45) Date of publication and mention of the grant of the patent: **26.01.2011**
(21) Application number: 06012638.0
(22) Date of filing: 20.06.2006
(51) Int. Cl.: H01L 21/677, H01L 21/673, B65D 85/48

(54) **Purge system for a product container and table for use in the purge system**
Ein Reingungssystem für einen Produktbehälter und ein Tisch in Verwendung in einem Reinigungssystem
Un système de purge pour un conteneur de produits et une table untilisée dans un système de purge

(30) Priority: 24.06.2005 JP 2005184788
(43) Date of publication of application: 27.12.2006
(73) Proprietor: TDK Corporation, Tokyo 103-8272 (JP)
(72) Inventor: Okabe, Tsutomu, Tokyo 103-8272 (JP); Suzuki, Hitoshi, Tokyo 103-8272 (JP)
(74) Representative: Grünecker, Kinkeldey, Stockmair & Schwanhäusser Anwaltssozietät

(56) References cited:
- US-A1- 2001 042 439
- US-A1- 2004 237 244
- US-B1- 6 199 604
- US-B1- 6 430 802

## Description

### BACKGROUND OF THE INVENTION

### Field of the Invention

The present invention relates to a product container employed for containing a product such as a semiconductor, a panel for a flat panel display, or an optical disk in a product manufacturing process conducted under a high clean envelopment, and a so-called load port for conducting an open/close operation of the container. In particular, the present invention relates to a purge system for replacing a gas sealed in a so-called front-opening unified pod (FOUP) where the product is used as an object to be contained in processing of wafer of the above product, mainly, a semiconductor wafer that is 300 mm in diameter, and a table used in structuring the purge system.

### Related Background Art

Up to now, in a process of manufacturing a semiconductor device, an overall factory in which a wafer is subjected to various processing is brought to a clean room state to cope with a demand for high cleaning during the process. However, as the diameter of the wafer increases, there arises a problem in obtaining the high clean envelopment through the above coping in terms of costs or the like. In recent years, means for ensuring a mini environment space that keeps the high cleaning degree with respect to the various processing devices.

In particular, the cleaning degree of the entire factory is not enhanced, but only interiors within the respective processing devices in a manufacturing process and an interior within a storage container (hereinafter referred to as "pod") during travel between the respective processing devices are kept to the high cleaning degree. The pod is generically named "FOUP" as described above. In this way, a so-called mini environment system that highly cleans only a slight space is applied, to thereby obtain the same effect as that in the case where the entire factory is brought to a clean room state, delete capital investment and maintenance costs, and realize the effective production process.

A purge operation table as defined in the preamble of claim 1 and as specified in the preamble of claim 3 is known from the United States Patent Application No. US 2004/0237244 A1.

United States Patent No. US 6,199,604 B1 and US 6,430,802 B1 and United States Patent Application No. US 2004/0237244 A1 also disclose such a purge operation table.

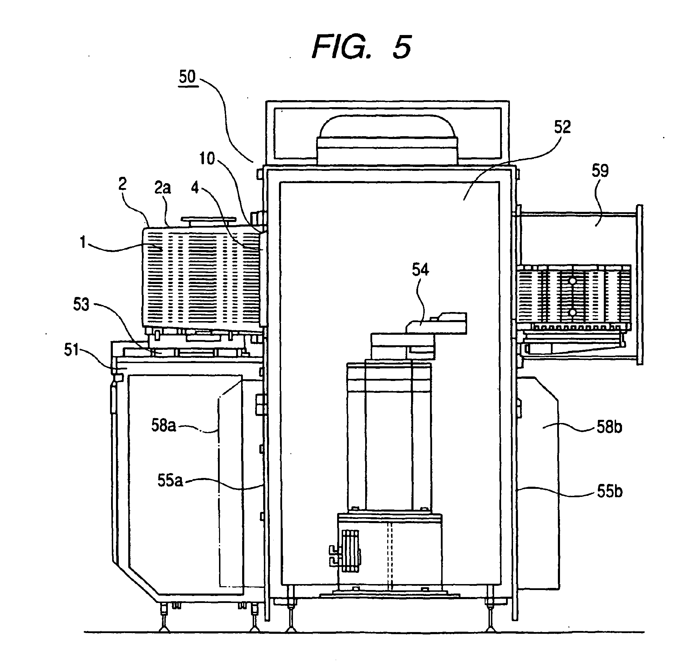

Hereinafter, a description will be briefly given of a semiconductor processing device that copes with the so-called mini environment system, which is actually employed. FIG. 5 shows the entirety of a semiconductor wafer processing device 50. The semiconductor wafer processing device 50 is mainly made up of a load port portion 51, a transport chamber 52, and a processing chamber 59. The respective joint portions are zoned by a partition 55a and a cover 58a at the load port side, and a partition 55b and a cover 58b at the processing chamber side. In the transport chamber 52 of the semiconductor wafer processing device 50, in order to exhaust dusts and keep the high cleaning degree, an airflow is generated from above of the transport 52 toward below by means of a fan (not shown) which is disposed on an upper portion of the transport chamber 52. With this arrangement, the dusts are always discharged toward downward.

A pod 2 that is a storage vessel of a product to be contained such as a silicon wafer (hereinafter referred to simply as "wafer") is installed on the load port portion 51. As described above, the interior of the transport chamber 52 is kept to the high cleaning degree in order to process a wafer 1, and a robot arm 54 is also disposed in the interior of the transport chamber 52. The wafer is transported between the interior of the pod 2 and the interior of the processing chamber 59 by the robot arm 54. Various mechanisms for subjecting a wafer surface to processing such as thin film formation or thin film processing are normally included in the processing chamber 59. Those structures are directly irrelevant to the present invention, and therefore their description will be omitted.

The pod 2 includes a box type main body portion 2a having a space for receiving the wafer 1 which is an object to be processed therein, and having an opening portion on any one side, and a cover 4 for tightly closing the opening portion. A rack having a plurality of steps for stacking the wafers 1 in one direction is arranged in the interior of the main body portion 2a. The respective wafers 1 that are mounted on the steps are contained in the interior of the pod 2 at constant intervals. In this example, the direction along which the wafers 1 are stacked is vertical. An opening portion 10 is defined at the load port portion 51 side of the transport chamber 52. The opening portion 10 is disposed at a position that faces the opening portion of the pod 2 when the pod 2 is disposed on the load port portion 51 so as to come close to the opening portion 10. Further, an opener (not shown) is disposed in the vicinity of the opening portion 10 within the transport chamber 52. After the opener removes the cover 4 from the pod 2, the operation of carrying in and out the wafer 1 is conducted by the robot arm 54.

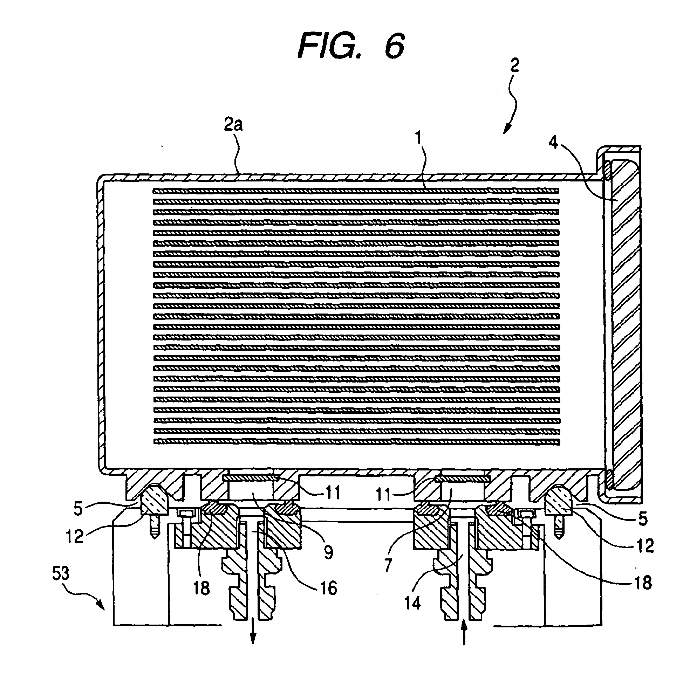

FIG. 6 schematically shows the structure of the table 53 shown in FIG. 5 and the pod 2 that is mounted on the table 53, which are observed along a longitudinal section thereof. A lower portion of the pod 2 has recesses 5, an inlet port 7, and an outlet port 9. Further, a surface of the table 53 is equipped with positioning pins 12 that are fitted into the recesses 5 to regulate the replacement position of the pod 2, a table inlet port 14 at the table 53 side which is abutted against the inlet port 7 at the pod 2 side, and a table output port 16 at the table 53 side which is abutted against the outlet port 9 at the pod 2 side. The opening portions of the inlet and outlet ports 14 and 16 at the table 53 side are equipped with sealing members 18 for enhancing the air-tightness of portions where the table inlet and outlet ports 14 and 16 are abutted against the ports at the pod 2 side.

Filter members 11 are disposed in the vicinity of the opening portions of the inlet and outlet ports 7 and 9 at the pod side so as to prevent dusts from entering the interior of the pod 2 through the ports 7 and 9. Further, the inlet port 14 and the outlet port 16 at the table 53 side are connected to substitution air discharge sources (not shown) which are external devices through a check valve (not shown) and a flow meter (not shown). Here, the FOUP as the pod 2 is normally made up of a resin mold product. Therefore, even in the case where a pressure within the pod is slightly different from an external pressure, the FOUP is deformed. For that reason, the above inlet and outlet ports are normally in open states, and those ports are used as breathing ports, and a difference between the internal pressure of the FOUP and the external pressure thereof is eliminated to prevent the deformation of the FOUP.

The above structure is schematically disclosed in, for example, Japanese Patent Application Laid-Open No. 2002-510150 and US Patent No. 6,164,664. Normally, the wafer 1 that suppresses the adhesion of dusts is taken in the above pod 2 for containing the product therein, and an internal atmosphere is replaced with an inactive gas such as clean nitrogen, to thereby suppress a chemical change such as native oxidation or the occurrence of organic contamination with respect to the wafer surface that is in a contained state. The above replacement operation of the internal atmosphere is conducted through a gas flow path that is formed of the inlet and outlet ports which are disposed in the pod 2 and the table 53, respectively, in a state where the pod 2 is placed on the table 53. Therefore, it is necessary that the gas flow path ensure a magnitude for allowing a sufficient amount of replacement gas or internal atmosphere to flow, and a sufficient air-tightness for preventing the displacement gat or the internal atmosphere from being contaminated. The sealing members 18 are demanded to ensure the sufficient sealing characteristic that satisfies those requirements.

In the case where the pod 2 is placed on the table 53, the inlet port 7 and the outlet port 9 form a completely closed loop as a gas circulating path through the interior of the pod by the sealing members 18. The formation of the closed loop prevents a leakage of gas from the interior of the pod to the exterior thereof, or an entrance of gas into the interior of the pod from the exterior thereof. However, in the case where a pressure balance between the gas inlet side and the gas outlet side is not kept in the above structure, a pressure difference between the interior of the pod 2 and the exterior thereof occurs, thereby leads a fear that the pod 2 is deformed. Further, in the case of a pod that contains a large substrate that is 300 mm or more in diameter, there is a fear that a sealing state between the pod main body 2a and the cover 4 is destabilized, and a so-called leakage occurs from the unstable sealing state.

As a method of preventing the pressure fluctuation from occurring, for example, US Patent No. 6,164,664 discloses a method of controlling a gas flow rate in the gas outlet path so as to introduce a supply of the gas into the interior of the pod by discharging the gas that exists within the pod. According to the above method, it is possible to suppress a gas outlet rate to some degree or less, and prevent a rapid pressure difference from occurring between the interior and the exterior of the pod. However, according to the method, a time required for purging becomes long all anyhow, and an improvement is further required in the productivity. Further, as the volume of the pod 2 becomes larger, a conductance difference between the inlet and outlet ports and the interior of the pod is larger. As a result, a time lag occurs between the movement of gas at the inlet side and the movement of gas at the outlet side, thereby increasing the conditions under which the pressure fluctuation occurs. In this case, the possibility of deformability of the pod 2 that is made of resin becomes large, and the occurrence of a slight pressure difference greatly contributes to the deformation of the pod 2. Further, the occurrence of a rapid and large pressure difference causes vibration of the wafer 1 that is held in the interior of the pod 2, resulting in a fear that the wafer per se is damaged in an extreme case.

### SUMMARY OF THE INVENTION

The present invention has been made in view of the above circumstances, and therefore an object of the present invention is to provide a purge system that is capable of preventing a pressure difference from occurring between an interior and an exterior of a pod in the purge operation of the interior of the pod 2, and a purge operation table in a load port which is used in structuring the purge system.

In order to solve the above problems, according to the present invention, there is provided apurge system according to claim 1.

Moreover, the above object is further solved by a purge system according to claim 3.

According to the present invention, a gas within the pod which is discharged from the outlet port in the pod and the atmosphere that exists around the outlet port are sucked and discharged at the same time by the outlet port in the purge system. As a result, it is possible to suppress a pressure difference from occurring between a inlet side pressure and an outlet side pressure of the gas, and it is possible to suppress a pressure difference between the interior and the exterior of the pod to prevent the pod from being deformed. In other words, in the present invention, in the case where the pressure difference between the interior and the exterior of the pod starts occurring, the atmosphere around the outlet port is supplied to the outlet port as a buffer. As a result, a large fluctuation within the pod due to the gas discharge is suppressed. Further, it is possible to purge the interior of the pod at a high rate after the pressure fluctuation has been suppressed, to thereby obtain the effect that a time required for purging is shortened.

In addition, it is more preferable to provide a valve shaped member having a so-called check operation that enables atmosphere introduction only when a given pressure difference occurs in a communication path that is a supply path in the case of supplying the atmosphere around the outlet port. The arrangement of the valve shaped member reduces the possibility that the atmosphere under which the moisture content is not managed in a normal state enters the interior of the pod, thereby making it possible to preferably maintain the environment of the interior of the pod.

The above and other objects, features, and advantages of the invention will become more apparent from the following detailed description taken in conjunction with the accompanying drawings.

### BRIEF DESCRIPTION OF THE DRAWINGS

FIG. 1 is a diagram schematically showing a structure of a main portion of an FOUP and a load port in a purge system according to an embodiment of the present invention;
FIG. 2 is a diagram showing a modified example of the embodiment shown in FIG. 1;
FIG. 3 is a diagram showing another modified example of the embodiment shown in FIG. 1;
FIG. 4 is a diagram showing the structure of a main portion of an FOUP and a load port in a purge system according to an embodiment of the present invention;
FIG. 5 is a side view entirely showing the schematic structure of a normal semiconductor wafer processing device to which the present invention and the conventional art are applied; and
FIG. 6 is a diagram schematically showing the main portion of a purge system that is made up of an FOUP and a load port in the conventional art.

### DESCRIPTION OF THE PREFERRED EMBODIMENT

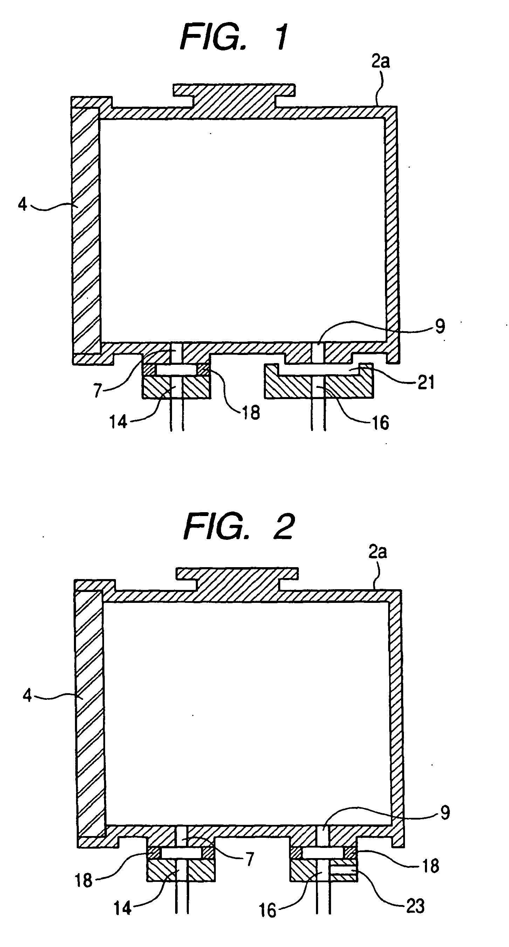

Now, a description will be given of embodiments of the present invention with reference to the accompanying drawings. FIG. 1 is a diagram schematically showing a purge system according to an embodiment of the present invention. To be more specific, FIG. 1 schematically shows a structure of a pod 2, and a table side inlet port 14 and a table side outlet port 16 which are disposed on a table 53 of FIG. 6, taken along a vertical section thereof. In the figure, the same structures as those of the respective structures shown in FIG. 5 as the conventional art are denoted by identical references for description.

Referring to FIG. 1, a sealing member 18 that is fixed to the table 53 side is interposed between an inlet port 7 of the pod 2 and a table side inlet port 14 that is connected to the inlet port 7. Therefore, a gas inlet system is completely sealed from an external space of the pod 2. On the contrary, no sealing member 18 is interposed between a outlet port 9 and a table side outlet port 16, thereby making it possible that a gas outlet system communicates with an external space of the pod 2. For that reason, even in the case where the flow rate of gas that is discharged to the exterior of the pod 2 through the outlet system is larger than the flow rate of gats that is sucked into the interior of the pod 2 through the inlet system, the atmosphere around the opening portion of the outlet port 9 is replenished through a gas-communication gap 21. As a result, an unbalance of the flow rates in the suction and discharge, or a time lag is eased by the atmosphere replenishing operation, thereby making it possible to suppress a pressure difference from occurring between the inlet port and the outlet port.

In this embodiment, the purge operation of the gas within the pod 2 is conducted by a low voltage source (not shown) which is disposed downstream of the table side outlet port and generates a negative pressure. Further, the conductance of the inlet system is made substantially identical with the conductance of the outlet system in the case where the sealing member 18 is interposed therebetween. Alternatively, it is also possible that a high pressure source that generates a positive pressure is disposed upstream of the table side inlet port, and the gas in the interior of the pod 2 is extruded by the gas that is supplied from the high voltage source to conduct the purge operation. In this case, for example, it is preferable that the conductance of the outlet system be set to be larger than the conductance of the inlet system (more specifically, there is proposed a modification such that the inner diameter of the outlet port is made larger), and the outlet resistance at the time of extruding the gas within the pod be reduced. However, in order to shorten a time required for purging, it is preferable to use both of the high voltage source and the low voltage source.

Subsequently, a description will be given of a modified example of the above-described embodiment with reference to FIG. 2 that is obtained in the same manner as that of FIG. 1. The same structures as those shown in FIG. 1 are denoted by identical reference symbols, and their description will be omitted. In this embodiment, the sealing member 18 is interposed between the outlet port 9 and the table side outlet port 16. However, a gas-communication path 23 that communicates with the external space is formed in the table side outlet port 16. The atmosphere around the outlet port is sucked or discharged by the outlet system through the gas-communication path 23. In other words, the present invention can also be implemented by provision of the gas-communication path that is capable of supplying the external atmosphere to the outlet system in the convention structure.

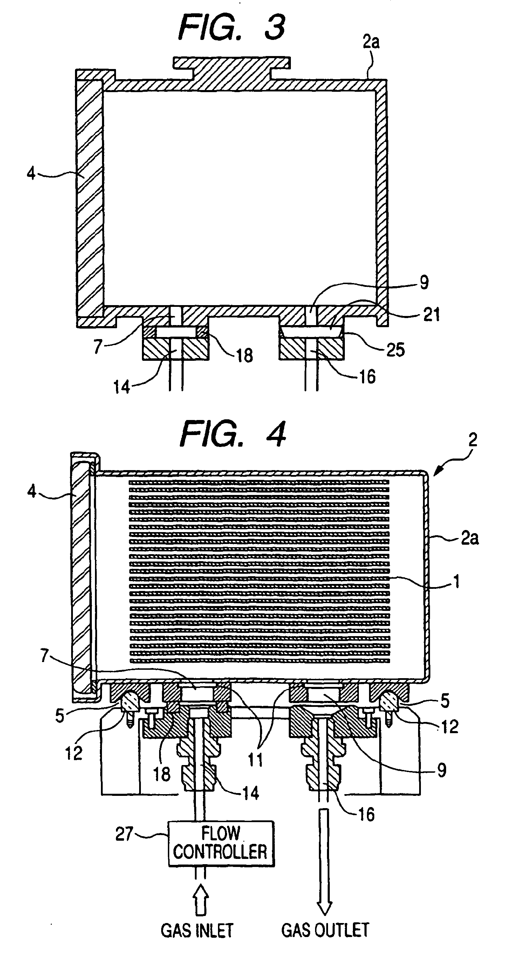

The atmosphere that exists around the outlet port is different from an inactive gas that is positively supplied to the interior of the pod 2, for example, dry nitrogen, and is not controlled in the moisture content, and is not also controlled in the contamination material of the organic system. Therefore, it is preferable to prevent the above atmosphere from entering the interior of the pod 2. Therefore, for example, as shown in FIG. 3, it is possible that a valve shaped member 25 having a so-called check preventing function with respect to the gas flow is disposed in a gas-communication gas 21 that is disposed between the outlet port 9 and the table side outlet port 16 and communicates with the exterior of the exhaust system.

The valve shaped member 25 is deformed and makes the external space communicate with the interior of the outlet system in the case where the interior of the outlet system generates a pressure difference by a given pressure with respect to the external space. Because the valve shaped member 25 is disposed in the gas-communication gap 21 or the gas-communication path 23, it is possible to reduce the risk that the atmosphere enters the interior of the pod 2 from the external space, and to obtain the effects of the present invention. In this embodiment, a film member that is bent by application of a pressure of some degree is disposed around the table side discharge port on the table 53 so as to be used as the valve shaped member 25. However, the configuration of the member is not limited to the above configuration. For example, it is possible that a normal so-called check valve is disposed in the communication path 23 according to the embodiment shown in FIG. 2, and the check valve is used as the valve shaped member. Further, the gas-communication path 23 is not limited to the gas-communication gap 21 shown in FIG. 1 or the path shown in FIG. 2, but may be structured by a configuration that is capable of introducing the external atmosphere with respect to the outlet path that extends from the table side discharge port. To be more specific, any configuration can be applied if the outlet path communicates with the external space.

Now, an embodiment of the present invention will be described below. FIG. 4 shows a purge system according to an embodiment of the present invention in the same manner as that of FIG. 6. The same structures as those shown in FIGS. 6 and 1 and the like are denoted by identical reference symbols for description.

A pod 2 includes recesses 5, an inlet port 7, and an outlet port 9 at a bottom surface thereof. Further, the surface of a table 53 on which the pod 2 is placed is equipped with positioning pins 12 that are fitted into the recesses 5 to regulate the placement position of the pod 2, a table side inlet port 14 that constitutes the inlet system in association with the inlet port 7 at the pod 2 side, and a table side outlet port 16 that constitutes the outlet system in association with the outlet port 9 at the pod 2 side. Further, a toric sealing member 18 is disposed between the inlet port 7 and the table side inlet port 14 facing each other to enhance the air-tightness with respect to the exterior of the pod 2 of the inlet system. No sealing member 18 is disposed between the outlet port 9 and the table side outlet port 16, and a gas-communication gap 21 having an interval that substantially corresponds to the sealing member 18 is formed between those ports when the positional relationship between the pod 2 and the table 53 is determined according to the recesses 5, the positioning pins 12, the inlet system, and the like.

Filter members 11 are disposed in the vicinity of the opening portions of the inlet and outlet ports 7 and 9 at the pod side so as to prevent dusts and the like from entering the interior of the pod 2 through the ports. Further, an upstream side of the table side inlet port 14 and a downstream side of the table side outlet port 16 in the gas flow are connected to a replacement gas inlet source and a replacement gas outlet source (not shown) which are external devices through a check valve and a flow meter (not shown), respectively. Further, in this embodiment, a flow controller 27 is disposed upstream of the table side inlet port 14 so as to control the flow rate of gas that is supplied to the interior of the pod 2.

Hereinafter, a description will be given of the purge operation and the like in an FOUP system to which the present invention is applied with reference to the drawings. First, the semiconductor wafer 1 is contained in the interior of the pod 2, and the pod 2 having the interior tightly closed by a cover 4 is transported above the table 53. The pod 2 is mounted on the table 53 in a state where the positioning pins 12 that project from the table 53 are substantially fitted into the recesses 5 that are disposed on the lower portion of the pod 2. In this state, the inlet port 7 at the pod side is abutted against the table side inlet port 14 that is disposed on the table 53 through the sealing member 18. Further, the outlet port 9 and the table side outlet port 16 face each other to form the gas-communication gap 21 therebetween.

In this example, the inlet system and the outlet system are connected to the replacement gas supply source and the replacement gas discharge source, respectively. In this situation, the flow rate of gas inlet for purging is set by the flow controller 27 in advance. In this situation, the gas for purging is sucked to the interior of the pod 2, and the gas within the pod 2 is discharged. When the magnitude of the replacement gas discharge source is set to be large, the sufficiently large gas discharge is conducted as compared with the gas suction, to thereby suppress the step-up of the internal pressure within the pod 2 due to the gas suction. Further, in the gas that is excessively discharged, the atmosphere is replenished through the gas-communication gap 21 to prevent the internal pressure of the interior of the pod 2 from being reduced. While this state is maintained, the purge operation within the pod 2 is conducted. In the purge operation, the replacement gas is circulated in the stated order of the table side inlet port 14, the sealing member 20, the inlet port 7 at the pod 2 side, the filter 11, the interior of the pod 2, the filter 11, the outlet port 9 at the pod 2 side, and the table side outlet port 16, to thereby replace the atmosphere within the pod 2.

In this embodiment, there are the table 53 in which the inlet port and the outlet port are formed by one system, respectively, and the pod 2 corresponding to the table 53. However, the configuration to which the present invention is applicable is not limited to the above structure, but it is preferable that the numbers of inlet ports and outlet ports be appropriately increased or decreased taking into consideration the demanded gas replacement speed, the capacity of the pod 2, and the like.

In the above first and second embodiments, the present system is applied to the FOUP, but the embodiment of the present invention is not limited to the above system. To be more specific, the system according to the present invention can be applied to a system having a container that receives a plurality of objects to be held (products) therein, and a transport chamber that transports the object to be held from the container to a device that processes the object to be held, in which the atmosphere within the container is purged.

As many apparently widely different embodiments of the present invention can be made without departing from the spirit and scope thereof, it is to be understood that the invention is not limited to the specific embodiments thereof except as defined in the appended claims.

## Claims

1. A purge system for purging an interior of a container (2) which contains a product therein with a predetermined replacement gas supplied from a replacement gas supply source,
wherein the container (2) comprises one surface having
a container side gas inlet port (7) adapted to supply the predetermined replacement gas to the interior of the container (2), and
a container side gas outlet port (9) adapted to discharge the predetermined replacement gas contained in the interior of the container (2) to an exterior of the container (2), wherein a purge operation table (53) comprises:
a table side gas inlet port (14) that is disposed on a facing surface of the purge operation table (53) with respect to the container (2) and is connected to the replacement gas supply source to supply the predetermined replacement gas into the container (2); and
a table side gas outlet port (16) that is disposed on the facing surface of the purge operation table (53) with respect to the container (2), and is connected to a replacement gas discharge source to discharge the predetermined replacement gas from the interior of the container (2) to the exterior of the container (2),
wherein, when the container (2) is placed on the purge operation table (53), the table side gas inlet port (14) engages the container side gas inlet port (7) and the table side gas outlet port (16) engages the container side gas outlet port (9) so that an airtightness with respect to the exterior of the container (2) is enhanced by an inlet side seal member (18) disposed between the table side gas inlet port (14) and the container side gas inlet port (7) and by an outlet side seal member (18) disposed between the table side gas outlet port (16) and the container side gas outlet port (9), wherein the table side gas outlet port (16) constitutes a gas outlet system in association with the container side gas outlet port (9),
**characterized in that**
a gas-communication path (23) is provided in the table side gas outlet port (16),
wherein the gas-communication path (23) communicates with an external atmosphere existing around the table side gas outlet port (16) to supply the external atmosphere to the gas outlet system.

2. The purge system according to claim 1, **characterized in that** a valve shaped member (25) having a check preventing function with respect to a gas flow is disposed in the gas-communication path (23) to allow introduction of the external atmosphere to the gas outlet system through the gas-communication path (23) when an interior of the gas outlet system generates a pressure difference by a given pressure with respect to an exterior of the gas outlet system.

3. A purge system for purging an interior of a container (2) which contains a product therein with a predetermined replacement gas supplied from a replacement gas supply source, the purge system comprises
the container (2) comprising one surface having
a container side gas inlet port (7) adapted to supply the predetermined replacement gas to the interior of the container (2), and
a container side gas outlet port (9) adapted to discharge the predetermined replacement gas contained in the interior of the container (2) to an exterior of the container (2), and
a purge operation table (53) comprising:
a table side gas inlet port (14) that is disposed on a facing surface of the purge operation table (53) with respect to the container (2) and is connected to the replacement gas supply source to supply the predetermined replacement gas into the interior of the container (2); and
a table side gas outlet port (16) that is disposed on the facing surface of the purge operation table (53) with respect to the container (2), and is connected to a replacement gas discharge source to discharge the predetermined replacement gas from the interior of the container (2) to the exterior of the container (2),
wherein the container (2) is placed on the purge operation table (53), wherein the table side gas inlet port (14) engages the container side gas inlet port (7) so that an airtightness with respect to the exterior of the container (2) is enhanced by a seal member (18) disposed between the table side gas inlet port (14) and the container side gas inlet port (7),
**characterized in that**
the table side gas outlet port (16) and the container side gas outlet port (9) face each other by providing no seal member therebetween, thereby forming a gas-communication gap (21) between the table side gas outlet port (16) and the container side gas outlet port (9), which gas-communication gap (21) communicates with an external atmosphere existing around the table side gas outlet port (16) and which gas-communication gap (21) is provided for supplying the external atmosphere to a gas outlet system which gas outlet system is constituted by the table side gas outlet port (16) In association with the container side gas outlet port (9).

4. The purge system according to claim 3, **characterized in that** a valve shaped member (25) having a check preventing function with respect to a gas flow is disposed in the gas-communication gap (21) to allow introduction of the external atmosphere to the gas outlet system through the gas-communication gap (21) when an interior of the gas outlet system generates a pressure difference by a given pressure with respect to an exterior of the gas outlet system.

## Patentansprüche

1. Spülsystem zum Spülen eines Innenraums eines Behälters (2), in dem ein Erzeugnis enthalten ist, mit einem vorgegebenen Austauschgas, das von einer Austauschgas-Zuführquelle zugeführt wird,
wobei der Behälter (2) eine Fläche umfasst, die aufweist:
einen behälterseitigen Gaseinlassanschluss (7), der zum Zuführen des vorgegebenen Austauschgases zu dem Innenraum des Behälters (2) eingerichtet ist, und
einen behälterseitigen Gasauslassanschluss (9), der zum Ableiten des vorgegebenen Austauschgases, das im Innenraum des Behälters (2) enthalten ist, zu einer Außenseite des Behälters (2) eingerichtet ist,
wobei ein Spülbetriebs-Tisch (53) umfasst:
einen tischseitigen Gaseinlassanschluss (14), der an einer dem Behälter (2) zugewandten Fläche des Spülbetriebs-Tischs (53) angeordnet ist und mit der Austauschgas-Zuführquelle verbunden ist, um dem Behälter (2) das vorgegebene Austauschgas zuzuführen; und
einen tischseitigen Gasauslassanschluss (16), der an der dem Behälter (2) zugewandten Fläche des Spülbetriebs-Tischs (53) angeordnet ist und mit einer Austauschgas-Ableitquelle zum Ableiten des vorgegebenen Austauschgases aus dem Innenraum des Behälters (2) zur Außenseite des Behälters (2) verbunden ist,
wobei, wenn der Behälter (2) auf den Spülbetriebs-Tisch (53) aufgesetzt wird, der tischseitige Gaseinlassanschluss (14) mit dem behälterseitigen Gaseinlassanschluss (7) in Eingriff kommt und der tischseitige Gasauslassanschluss (16) mit dem behälterseitigen Gasauslassanschluss (9) derart in Eingriff kommt, dass Luftdichtigkeit in Bezug auf die Außenseite des Behälters (2) durch ein einlassseitiges Dichtungselement (18), das zwischen dem tischseitigen Gaseinlassanschluss (14) und dem behälterseitigen Gaseinlassanschluss (7) angeordnet ist, sowie durch ein auslassseitiges Dichtungselement (18) verbessert wird, das zwischen dem tischseitigen Gasauslassanschluss (16) und dem behälterseitigen Gasauslassanschluss (9) angeordnet ist, und wobei der tischseitige Gasauslassanschluss (16) ein Gasauslasssystem in Verbindung mit dem behälterseitigen Gasauslassanschluss (9) bildet,
**dadurch gekennzeichnet, dass**
ein Gasverbindungsweg (23) in dem tischseitigen Gasauslassanschluss (16) vorgesehen ist, wobei der Gasverbindungsweg (23) mit einer äußeren Atmosphäre in Verbindung steht, die um den tischseitigen Gasauslassanschluss (16) herum vorhanden ist, um dem Gasauslasssystem die äußere Atmosphäre zuzuführen.

2. Spülsystem nach Anspruch 1, **dadurch gekennzeichnet, dass** ein ventilförmiges Element (25), das eine Unterbrechungsverhinderungsfunktion in Bezug auf einen Gasstrom hat, in dem Gasverbindungsweg (23) angeordnet ist, um Einleiten der äußeren Atmosphäre in das Gasauslasssystem über den Gasverbindungsweg (23) zu ermöglichen, wenn ein Innenraum des Gasauslasssystems eine Druckdifferenz um einen bestimmten Druck in Bezug auf eine Außenseite des Gasauslasssystems erzeugt.

3. Spülsystem zum Spülen eines Innenraums eines Behälters (2), in dem ein Erzeugnis enthalten ist, mit einem vorgegebenen Austauschgas, das von einer Austauschgas-Zuführquelle zugeführt wird, wobei das Spülsystem umfasst:
den Behälter (2), der eine Fläche umfasst, die aufweist:
einen behälterseitigen Gaseinlassanschluss (7), der zum Zuführen des vorgegebenen Austauschgases zu dem Innenraum des Behälters (2) eingerichtet ist, und
einen behälterseitigen Gasauslassanschluss (9), der zum Ableiten des vorgegebenen Austauschgases, das im Innenraum des Behälters (2) enthalten ist, zu einer Außenseite des Behälters (2) eingerichtet ist,
einen Spülbetriebs-Tisch (53), der umfasst:
einen tischseitigen Gaseinlassanschluss (14), der an einer dem Behälter (2) zugewandten Fläche des Spülbetriebs-Tischs (53) angeordnet ist und mit der Austauschgas-Zuführquelle verbunden ist, um dem Innenraum des Behälters (2) das vorgegebene Austauschgas zuzuführen; und
einen tischseitigen Gasauslassanschluss (16), der an der dem Behälter (2) zugewandten Fläche des Spülbetriebs-Tischs (53) angeordnet ist und mit einer Austauschgas-Ableitquelle zum Ableiten des vorgegebenen Austauschgases aus dem Innenraum des Behälters (2) zur Außenseite des Behälters (2) verbunden ist,
wobei der Behälter (2) auf den Spülbetriebs-Tisch (53) aufgesetzt wird, der tischseitige Gaseinlassanschluss (14) mit dem behälterseitigen Gaseinlassanschluss (7) in Eingriff kommt, so dass eine Luftdichtigkeit in Bezug auf die Außenseite des Behälters (2) durch ein Dichtungselement (18) verbessert wird, das zwischen dem tischseitigen Gaseinlassanschluss (14) und dem behälterseitigen Gaseinlasseinlass (7) angeordnet ist, **dadurch gekennzeichnet, dass**
der tischseitige Gasauslassanschluss (16) und der behälterseitige Gasauslassanschluss (9) einander zugewandt sind, ohne dass ein Dichtungselement zwischen ihnen vorhanden ist, so dass ein Gasverbindungs-Zwischenraum (21) zwischen dem tischseitigen Gasauslassanschluss (16) und dem behälterseitigen Gasauslassanschluss (9) ausgebildet wird, wobei dieser Gasverbindungs-Zwischenraum (21) mit einer äußeren Atmosphäre in Verbindung steht, die um den tischseitigen Gasauslassanschluss (16) herum existiert und wobei dieser Gasverbindungs-Zwischenraum (21) vorhanden ist, um die äußere Atmosphäre einem Gasauslasssystem zuzuführen, welches durch den tischseitigen Gasauslassanschluss (16) in Verbindung mit dem behälterseitigen Gasauslassanschluss (9) gebildet wird.

4. Spülsystem nach Anspruch 3, **dadurch gekennzeichnet, dass** ein ventilförmiges Element (25), das eine Unterbrechungsverhinderungsfunktion in Bezug auf einen Gasstrom hat, in dem Gasverbindungs-Zwischenraum (21) angeordnet ist, um Einleiten der äußeren Atmosphäre in das Gasauslasssystem über den Gasverbindungs-Zwischenraum (21) zu ermöglichen, wenn ein Innenraum des Gasauslasssystems eine Druckdifferenz um einen bestimmten Druck in Bezug auf eine Außenseite des Gasauslasssystems erzeugt.

## Revendications

1. Système de purge pour purger un intérieur d'un conteneur (2) qui contient un produit en son sein avec un gaz de remplacement prédéterminé fourni en provenance d'une source d'alimentation en gaz de remplacement,
dans lequel le conteneur (2) comprend une surface ayant
un orifice d'entrée de gaz côté conteneur (7) conçu pour amener le gaz de remplacement prédéterminé à l'intérieur du conteneur (2), et
un orifice de sortie de gaz côté conteneur (9) conçu pour décharger le gaz de remplacement prédéterminé contenu dans l'intérieur du conteneur (2) vers un extérieur du conteneur (2), dans lequel une table de mise en oeuvre de purge (53) comprend :
un orifice d'entrée de gaz côté table (14) qui est disposé sur une surface de la table de mise en oeuvre de purge (53) faisant face au conteneur (2) et est relié à la source d'alimentation en gaz de remplacement pour amener le gaz de remplacement prédéterminé dans le conteneur (2) ; et
un orifice de sortie de gaz côté table (16) qui est disposé sur la surface de la table de mise en oeuvre de purge (53) faisant face au conteneur (2) et est relié à une source de décharge de gaz de remplacement pour décharger le gaz de remplacement prédéterminé depuis l'intérieur du conteneur (2) vers l'extérieur du conteneur (2),
dans lequel, lorsque le conteneur (2) est placé sur la table de mise en oeuvre de purge (53), l'orifice d'entrée de gaz côté table (14) s'engage avec l'orifice d'entrée de gaz côté conteneur (7) et l'orifice de sortie de gaz côté table (18) s'engage avec l'orifice de sortie de gaz côté conteneur (9) de sorte qu'une étanchéité à l'air par rapport à l'extérieur du conteneur (2) est améliorée par un élément formant joint côté entrée (18) disposé entre l'orifice d'entrée de gaz côté table (14) et l'orifice d'entrée de gaz côté conteneur (7) et par un élément formant joint côté sortie (18) disposé entre l'orifice de sortie de gaz côté table (16) et l'orifice de sortie de gaz côté conteneur (9), dans lequel l'orifice de sortie de gaz côté table (16) constitue un système de sortie de gaz en association avec l'orifice de sortie de gaz côté conteneur (9),
**caractérisé en ce que**
un chemin de communication de gaz (23) est prévu dans l'orifice de sortie de gaz côté table (16), dans lequel le chemin de communication de gaz (23) communique avec une atmosphère externe existant autour de l'orifice de sortie de gaz côté table (16) pour amener l'atmosphère externe au système de sortie de gaz.

2. Système de purge selon la revendication 1, **caractérisé en ce qu'**un élément en forme de vanne (25) ayant une fonction antiretour en ce qui concerne un écoulement de gaz est disposé dans le chemin de communication de gaz (23) pour permettre l'introduction de l'atmosphère externe dans le système de sortie de gaz à travers le chemin de communication de gaz (23) quand un intérieur du système de sortie de gaz produit une différence de pression d'une pression donnée par rapport à un extérieur du système de sortie de gaz.

3. Système de purge pour purger une intérieur d'un conteneur (2) qui contient un produit en son sein avec un gaz de remplacement prédéterminé fourni en provenance d'une source d'alimentation en gaz de remplacement, le système de purge comprend
le conteneur (2) comprenant une surface ayant
un orifice d'entrée de gaz côté conteneur (7) conçu pour amener le gaz de remplacement prédéterminé à l'intérieur du conteneur (2), et
un orifice de sortie de gaz côté conteneur (9) conçu pour décharger le gaz de remplacement prédéterminé contenu dans l'intérieur du conteneur (2) vers un extérieur du conteneur (2), et
une table de mise en oeuvre de purge (53) comprenant :
un orifice d'entrée de gaz côté table (14) qui est disposé sur une surface de la table de mise en oeuvre de purge (53) faisant face au conteneur (2) et est relié à la source d'alimentation en gaz de remplacement pour amener le gaz de remplacement prédéterminé dans l'intérieur du conteneur (2) ; et
un orifice de sortie de gaz côté table (16) qui est disposé sur la surface de la table de mise en oeuvre de purge (53) faisant face au conteneur (2), et est relié à une source de décharge de gaz de remplacement pour décharger le gaz de remplacement prédéterminé depuis l'intérieur du conteneur (2) vers l'extérieur du conteneur (2),
dans lequel le conteneur (2) est placé sur la table mise en oeuvre de purge (53), dans lequel l'orifice d'entrée de gaz côté table (14) s'engage avec l'orifice d'entrée de gaz côté conteneur (7) de sorte qu'une étanchéité à l'air par rapport à l'extérieur du conteneur (2) est améliorée par un élément formant joint (18) disposé entre l'orifice d'entrée de gaz côté table (14) et l'orifice d'entrée de gaz côté conteneur (7),
**caractérisé en ce que**
l'orifice de sortie de gaz côté table (16) et l'orifice de sortie de gaz côté conteneur (9) se font face en ne prévoyant aucun élément formant joint entre ces derniers, formant de ce fait un espacement de communication de gaz (21) entre l'orifice de sortie de gaz côté table (16) et l'orifice de sortie de gaz côté conteneur (9), lequel espacement de communication de gaz (21) communique avec une atmosphère externe existant autour de l'orifice de sortie de gaz côté table (16) et lequel espacement de communication de gaz (21) est prévu pour amener l'atmosphère externe à un système de sortie de gaz, lequel système de sortie de gaz est constitué par l'orifice de sortie de gaz côté table (16) en association avec l'orifice de sortie de gaz côté conteneur (9).

4. Système de purge selon la revendication 3, **caractérisé en ce qu'**un élément en forme de vanne (25) ayant une fonction antiretour par rapport à un écoulement de gaz est disposé dans l'espacement de communication de gaz (21) pour permettre l'introduction de l'atmosphère externe dans le système de sortie de gaz à travers l'espacement de communication de gaz (21) quand un intérieur du système de sortie de gaz produit une différence de pression d'une pression donnée par rapport à un extérieur du système de sortie de gaz.
